# EUROPEAN PATENT APPLICATION

(11) **EP 4 760 314 A1**
(43) Date of publication of application: **17.06.2026**
(21) Application number: 24220211.7
(22) Date of filing: 16.12.2024
(51) Int. Cl.: G01R 31/396, G01R 35/00, G01R 31/382

(54) **SENSOR ASSEMBLY FOR A BATTERY CELL STRING OF A BATTERY ASSEMBLY FOR A VEHICLE, BATTERY ASSEMBLY FOR A VEHICLE, VEHICLE, AND METHOD FOR CONTROLLING A SENSOR ASSEMBLY**

(71) Applicant: Volvo Car Corporation, 405 31 Göteborg (SE)
(72) Inventor: FORSSELL, Jonas, 40531 Göteborg (SE); ERIKSSON, Robert, 40531 Göteborg (SE); SIDIROPOULOS, Nikitas, 40531 Göteborg (SE); EKSTRÖM, Markus, 40531 Göteborg (SE); GAD, Darshan, 40531 Göteborg (SE)
(74) Representative: Kransell & Wennborg KB

(57) **Abstract**

The disclosure relates to a sensor assembly (26) for a battery cell string (22) of a battery assembly (18) for a vehicle. The sensor assembly (26) comprises a plurality of first sensors (28) each configured to measure an electric current. Each first sensor (28) is associateable to a single battery cell (20) or a group of battery cells of the battery cell string (22). The sensor assembly (26) further comprises a second sensor (30) configured to measure an electric current. The second sensor (30) is associateable to the battery cell string (22). The first sensors (28) and the second sensor (30) have different measurement accuracies. The first sensors (28) and the second sensor (30) are communicatively connected. Additionally, a battery assembly (18) for a vehicle is described. Furthermore, a vehicle is shown. Also, a method for controlling a sensor assembly (26) is presented.

## Description

### TECHNICAL FIELD

The present disclosure relates to a sensor assembly for a battery cell string of a battery assembly for a vehicle.

Moreover, the present disclosure is directed to a battery assembly for a vehicle.

Additionally, the present disclosure relates to a vehicle.

Furthermore, the present disclosure is directed to a method for controlling a sensor assembly.

### BACKGROUND ART

Recent developments in the field of battery electric vehicles show that different monitoring systems are used to assess the state-of-health of battery systems over time. This becomes especially important during charging and discharging of the battery system. Due to the increasing energy density in such battery systems, potential defects in the battery system need to be detected early to ensure safety of the system. Such defects may include overheating of the battery system, which could damage the system. At the same time, battery systems shall be kept as simple as possible in order to facilitate production, maintenance and repair.

### SUMMARY

It is therefore an objective of the present disclosure to solve or alleviate the conflict of objectives between high reliability and structural simplicity. In other words, reliable operation of the battery system shall be ensured while keeping the battery system structurally simple.

The problem is at least partially solved or alleviated by the subject matter of the independent claims of the present disclosure, wherein further examples are incorporated in the dependent claims.

According to a first aspect, there is provided a sensor assembly for a battery cell string of a battery assembly for a vehicle. The sensor assembly comprises a plurality of first sensors. Each first sensor is configured to measure an electric current. Moreover, each first sensor is associateable to a single battery cell or a group of battery cells of the battery cell string. The sensor assembly further comprises a second sensor configured to measure an electric current. The second sensor is associateable to the battery cell string. The first sensors and the second sensor have different measurement accuracies. The first sensors and the second sensor are communicatively connected. In this context, the battery cell string may be understood as a plurality of battery cells electrically connected in series to each other. Additionally, the battery cells of a battery cell string may be arranged side-by-side along an arrangement direction, e.g. stacked upon one another. The first sensors can be designated as cell-level sensors. This means that each first sensor may measure the electric current of an associated individual battery cell or of an associated group of battery cells. Thus, each first sensor measures the electric current of at least one battery cell within the battery cell string. The second sensor may be seen as a cell string-level sensor and/or a master sensor. The second sensor may be arranged at a different location than the first sensors. The second sensor may be located on a master board of the sensor assembly. The second sensor may measure the electric current of the battery cell string as a whole. Measurement accuracy may be understood as a degree of conformity of the measure to a standard or a true value. In other words, it may stand for a degree to which the electric current measurement is exact or correct. Measurement accuracy may also be seen as a measurement precision. Using the plurality of first sensors and the second sensor to measure the electric current at different positions may improve the measurement accuracy. This is because multiple sensors measuring electric current at various positions of the battery cell string allow a more accurate monitoring over time. It is understood that, due to the series-connection of the battery cells, the electric current in each of the battery cells of a battery cell string is the same in an idealized case. Moreover, if one of the plurality of first sensors fails, the sensor assembly may still use measurement data from the other first sensors in order to provide an estimation of a measurement result for the failed first sensor. Thus, the reliability of the overall measurement is high. Furthermore, the first sensors and the second sensor having different measurement accuracies may help detecting measurement errors. If one of the first sensors or the second sensor fails, the sensor assembly may still be capable of identifying potential anomalies in electric current measurements based on the measurements of the remaining sensors. In other words, the fact that a plurality of first sensors are used and that a second sensor is used on cell string-level provides redundancy within the sensor assembly. Using sensor having different measurement accuracies, i.e. sensor having a comparatively high measurement accuracy in combination with sensors having a comparatively low measurement accuracy, can be advantageous from a structural point of view since the sensors with comparatively low measurement accuracy may be simpler than the sensors with comparatively high measurement accuracy. Moreover, the sensors having a lower measurement accuracy may allow an easier production, maintenance or repair of the sensor assembly. Furthermore, sensors having a lower measurement accuracy may be simply cheaper than sensors having a higher measurement accuracy. In this context, the different measurement accuracies may be compensated by allowing a calibration and validation of the respective less accurate sensors based on a measurement of the sensor having a higher accuracy. Thus, overall the sensor assembly is highly accurate.

According to an example, the measurement accuracy of the first sensors is lower than the measurement accuracy of the second sensor. In an example, the measurement accuracy may be expressed in a tendency to drift. This means that the first sensors may have a higher tendency to drift than the second sensor. Such a drift may for example be a drift over temperature, i.e. the drift is due to varying temperature, a drift over usage, i.e. the drift is due to usage of the sensor, and/or a drift over time, i.e. the drift occurs over time. Thus, using the second sensor, the drift of the first sensors may be compensated, e.g. by re-calibration based on the measurement results of the second sensor.

According to an example, the first sensors use a first sensor technology and the second sensor uses a second sensor technology which is different from the first sensor technology. Generally, different sensor technologies have different measurement strengths or advantages. Thus, using different sensor technologies may result in more accurate and reliable measurements because different technologies can be used complementarily. It is noted that different sensor technologies also may have different sources of errors. This may even further improve the reliability of the sensor assembly as the different measurements may be used to reduce the number of false measurements. Moreover, certain sensor technologies may be advantageous from the perspective of production, maintenance or repair. Furthermore, some sensor technologies may be simply cheaper than others. Altogether, using different sensor technologies allows to combine advantages of different sensor technologies while compensating the disadvantages.

In an example, the first sensor technology and/or the second sensor technology comprise hall sensors, Rogowski coils, shunt resistors and/or thermal sensors.

According to an example, the first sensors and the second sensor are wirelessly connected to each other. The wireless connection may be achieved using a radio signal, a Bluetooth signal, and/or a WiFi signal. The wireless connection has the effect that the first sensors and the second sensor may be positioned independently at various locations without being restricted by cables. Thus, the flexibility of the first sensors and the second sensor may be improved. Further, the assembling process of the sensor assembly may be facilitated since there is no need to lay cables for the communicative connection between the first sensors and the second sensor. Moreover, the wireless connection is less susceptible to mechanical damage compared to cables.

According to an example, the measurement accuracy of the first sensors and the measurement accuracy of the second sensor deviate by at least 5%.

According to a second aspect, there is provided a battery assembly for a vehicle. The battery assembly comprises at least one sensor assembly of the first aspect and a plurality of battery cells arranged in at least one battery cell string. Each first sensor of the sensor assembly is associated to a single battery cell or a group of battery cells of the battery cell string. The second sensor of the sensor assembly is associated to the battery cell string. It is noted that there may be more than one battery cell string in the battery assembly. If so, at least some of the battery cell strings may be equipped with a sensor assembly according to the first aspect. Due to the fact that the sensor assembly allows for a high accuracy and reliability of the electric current measurement, such characteristics are also applicable to the battery assembly for the vehicle. Based thereon, the use of the plurality of first sensors and the second sensor may further lead to an improved performance of a battery assembly since a control of such battery assembly may be improved. This is because an improved accuracy and reliability of the sensor assembly may facilitate using the measurement data in a control unit. The same applies to monitoring of a state-of-health of the battery assembly.

In an example, the plurality of battery cells may be cylindrical battery cells or prismatic battery cells.

According to an example, each battery cell string is equipped with a sensor assembly of the first aspect. In other words, one sensor assembly is assigned to one battery cell string such that a precise measurement of the electric current may be achieved. This is because in case at least two battery cell strings are used, at least two sensor assemblies are implemented.

In an example, the battery assembly comprises at least two sensor assemblies. The at least two sensor assemblies may be communicatively connected to each other. If one of the first sensors or the second sensors of a single sensor assembly fails, the other second sensors and first sensors of other sensor assemblies may still use measurement data of other battery cell strings. Thus, the reliability of the overall measurement may be further enhanced.

According to a third aspect, there is provided a vehicle. The vehicle comprises a battery assembly of the second aspect. Consequently, the vehicle also comprises at least one sensor assembly according to the first aspect of the present disclosure. Due to the fact that the sensor assembly allows for a high accuracy and reliability of the electric current measurement, such characteristics are also applicable to the battery assembly and, thus, the vehicle. Based thereon, the use of the plurality of first sensors and the second sensor may further lead to an improved performance of the battery assembly and the vehicle. This is because an improved accuracy and reliability of the sensor assembly and, thus, the vehicle may facilitate using the measurement data in a control unit. The same applies to monitoring of a state-of-health of the battery assembly and, thus, the vehicle.

According to a fourth aspect, there is provided a method for controlling a sensor assembly of the first aspect. The method comprises calibrating at least one of the first sensors based on a measurement by the second sensor. In this case, a measurement accuracy of the second sensor is higher than the measurement accuracy of the first sensors. Thus, when the at least one first sensor is calibrated based on the measurement of the second sensor, the measurement of the at least one first sensor is adjusted and validated using the precise measurement data from the second sensor. This ensures that the at least one first sensor provides accurate and reliable measurement data. The calibration has the effect that accurate measurements are provided by the first sensors because errors and inaccuracies of the at least one first sensor are corrected by the precise data from the second sensor. Further, the calibration may keep the at least one first sensor up-to-date, further increasing the reliability of the at least one first sensor. Moreover, the calibration may help minimizing long-term drift and/or deviation of the measurement data of the at least one first sensor. Thus, the measurement stability of the at least one first sensor may be improved. At the same time the positive effects that may result from sensors having a comparatively low measurement accuracy may be used, e.g. structural simplicity, easy production, maintenance or repair or simply low costs.

According to an example, the calibration is time-triggered, event-triggered or regular. This means that there are three alternatives. The first alternative comprises the calibration being time-triggered. In this context, time-triggered may be understood as the calibration occurring after the lapse of a predefined time. This ensures that the first sensor is continuously checked and adjusted regardless of external circumstances or sudden changes of measurement data. This has the effect that a consistent accuracy of the at least one first sensor is achieved. Further, a time-triggered calibration may allow an automatic adjustment, reducing complexity and increasing efficiency of the calibration. The second alternative comprises the calibration being event-triggered. In this context, event-triggered may be understood as the calibration being initiated due to the occurrence of a specific predefined event and/or condition and/or situation. Such predefined events and/or conditions and/or situations may be reaching a predefined electric current value. Additionally or alternatively, the event-triggered calibration may include detecting discrepancies in measurement data or reaching certain operational thresholds. This has the effect that the calibration is performed exactly when it is needed, leading to immediate correction of inaccuracies of measurement data of the at least one first sensor. Further, the event-triggered calibration occurs only when needed, increasing performance and efficiency of the calibration. The third alternative comprises the calibration being regular. In this context, regular may be seen as the calibration occurring in accordance with a predefined pattern or rule. This rule may relate to a time schedule. Thus, the at least one first sensor may be continuously monitored and adjusted to maintain its accuracy. The regular calibration may help providing consistent accuracy of the at least one first sensor by making the necessary adjustments. The regular calibration may further increase the reliability of the at least one first sensor because the calibration is conducted predictably, keeping the measurement data consistent.

According to an example, a trigger event relates to a measurement result of a first sensor deviating from a measurement result of the second sensor by more than a predefined calibration threshold. This means that the event-triggered calibration may be performed, whenever a significant discrepancy between the measurement data of the at least one first sensor and the measurement data of the second sensor occurs. This has the effect that the accuracy of the at least one first sensor may be further improved because the calibration is performed immediately when a measurement data shows an unexpected deviation. Furthermore, such calibration may be seen as a dynamic adjustment of the at least one first sensor such that the at least one first sensor adapt its measurement data with respect to the changing specific predefined events and/or conditions. Thus, the calibration accuracy may be further enhanced.

According to an example, a trigger event is determined using an artificial neural network. Using the artificial neural network in this context helps to perform the calibration based on complex patterns and anomalies determined by a machine learning method. The artificial neural network may allow a detection of more precise and complex patterns such that the accuracy of the calibration may be further improved. Additionally, the calibration of the sensor assembly may dynamically adapt to new conditions and measurement data because the artificial neural network continuously trains its model. Therefore, the adaptability and reliability of the calibration may be even further enhanced.

It should be noted that the above examples may be combined with each other irrespective of the aspect involved.

These and other aspects of the present disclosure will become apparent from and elucidated with reference to the examples described hereinafter.

### BRIEF DESCRIPTION OF DRAWINGS

Examples of the disclosure will be described in the following with reference to the following drawings.
- Figure 1: shows a vehicle according to the present disclosure having a drive unit comprising a battery assembly according to the present disclosure, wherein the battery assembly includes three sensor assemblies according to the present disclosure, and wherein each sensor assembly is controlled using a method according to the present disclosure,
- Figure 2: shows the vehicle of Figure 1 in a more detailed view, wherein the perspective of a bottom view is taken, and
- Figure 3: schematically shows the drive unit of Figure 2 in a more detailed manner.

### DETAILED DESCRIPTION

The Figures are merely schematic representations and serve only to illustrate examples of the disclosure. Identical or equivalent elements are in principle provided with the same reference signs.

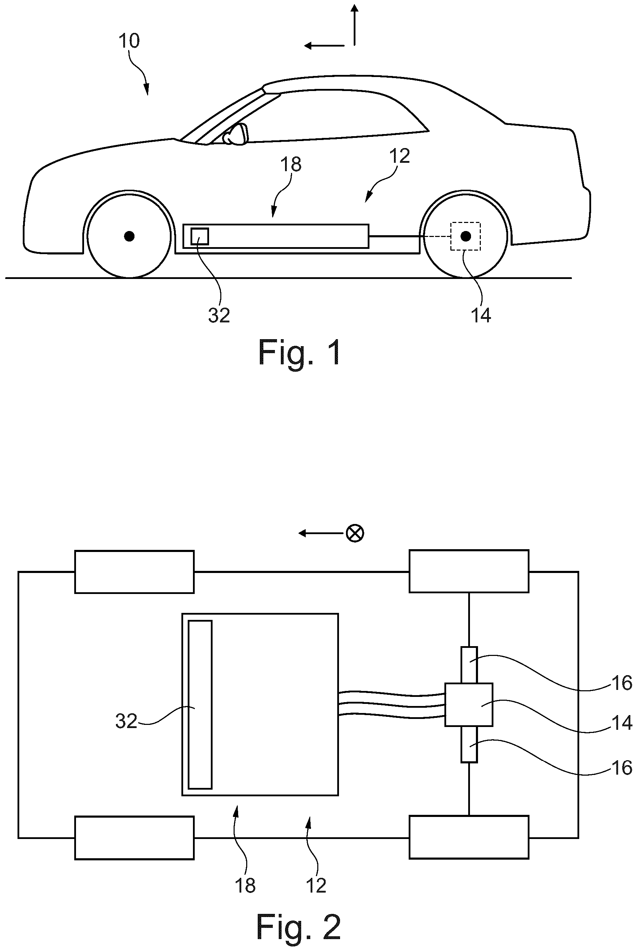

Figure 1 shows a vehicle 10 that comprises a drive unit 12 which may also be called a drivetrain.

The drive unit 12 comprises an electric machine 14.

The electric machine 14 can actuate a drive shaft 16 such that two rear wheels are rotating to drive the vehicle 10 (see Figure 2).

Thus, in the present example, the vehicle 10 comprises a rear-wheel drive.

The drive unit 12 further comprises a battery assembly 18 that can also be called a battery system.

The electric energy stored in the battery assembly 18 may be used to power the electric machine 14.

Thus, in the present example, the vehicle 10 is a battery electric vehicle.

The battery assembly 18 comprises a plurality of battery cells 20.

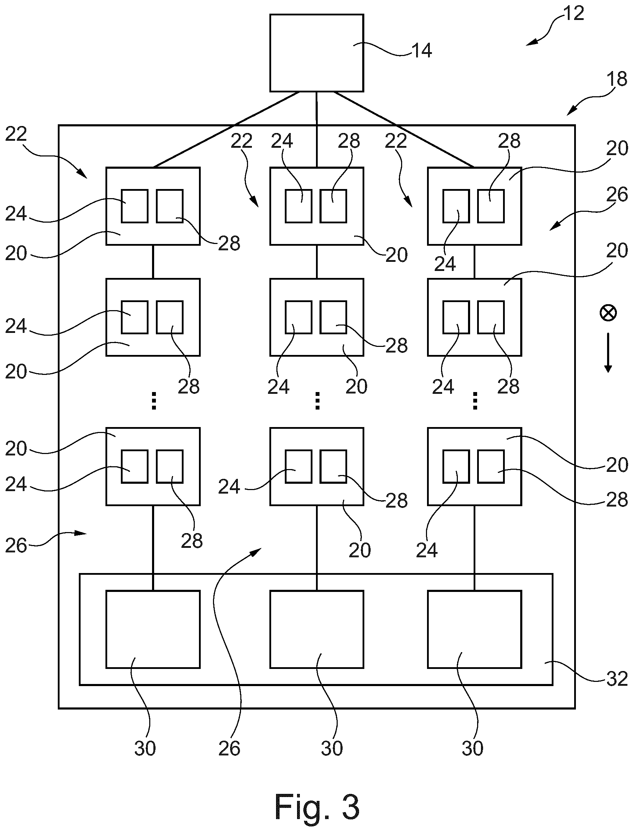

In the present example, the plurality of battery cells 20 is arranged in three battery cell strings 22 (see Figure 3). In the example of Figure 3, each battery cell string 22 extends in a top-down direction.

It is to be noted that there may be other examples, wherein a different number of battery cell strings 22 is formed from the plurality of battery cells 20.

The battery assembly 18 further comprises a plurality of cell-level inverter units 24.

In the present example, each battery cell 20 of each corresponding battery cell string 22 is equipped with and electrically connected to one cell-level inverter unit 24.

Each cell-level inverter unit 24 is electrically connected to the associated battery cell 20 and to the electric machine 14. Thus, direct current originating from the associated battery cell 20 is input into the cell-level inverter unit 24. The cell-level inverter units are configured to convert the direct current into an alternating current which then is provided to the electric machine 14.

The battery assembly 18 further comprises three sensor assemblies 26.

Each battery cell string 22 is equipped with one sensor assembly 26.

Each sensor assembly 26 comprises a plurality of first sensors 28 configured to measure an electric current.

Each first sensor 28 of each sensor assembly 26 is associated to a single battery cell 20 of the corresponding battery cell string 22.

This means that each first sensor 28 is configured to measure an electric current that enters and/or exits the corresponding battery cell 20.

It is noted that even though represented separate from one another, each first sensor 28 may be part of the corresponding cell-level inverter unit 24 that is electrically connected to the same battery cell 20.

Each sensor assembly 26 further comprises a second sensor 30 configured to measure an electric current.

Each second sensor 30 is arranged on a master board 32.

The second sensor 30 of each of the sensor assemblies 26 is associated to the corresponding battery cell string 22.

This means that each second sensor 30 is configured to measure an electric current that enters and/or exits the associated battery cell string 22.

In the present example, the first sensors 28 use a first sensor technology and the second sensor 30 uses a second sensor technology which is different from the first sensor technology.

Therefore, the first sensors 28 and the second sensor 30 of each sensor assembly 26 have different measurement accuracies.

In the present example, the measurement accuracy may be expressed in a tendency to drift. This means that the first sensors 28 have a higher tendency to drift than the second sensor 30. Thus, the measurement accuracy of the second sensor 30 is higher than the measurement accuracy of the first sensors 28.

The first sensors 28 and the second sensor 30 of each sensor assembly 26 are communicatively connected to one another.

It is noted that the first sensors 28 and the second sensor 30 of all three battery cell strings 22 altogether may be communicatively connected.

In more detail, in the present example, the first sensors 28 and the second sensor 30 are wirelessly connected.

Each sensor assembly 26 may be controlled in accordance with the following method which comprises calibrating at least one of the first sensors 28 based on a measurement by the second sensor 30. In this context, the second sensor 30 associated with the same battery cell string 22 as the first sensor 28 to be calibrated is used for the calibration.

Such a calibration may especially be needed in case a measurement of the at least one of the first sensors 28 deviates from a measurement of the second sensor 30.

Thus, the accuracy of the measurements of the at least one of the first sensors 28 can be aligned with the measurements of the second sensor 30.

Thus, in the present example, the calibration is event-triggered.

A trigger event relates to a measurement result of a first sensor 28 deviating from a measurement result of the second sensor 30 by more than a predefined calibration threshold.

In an example, the first sensor 28 measures an electric current exiting the corresponding battery cell 20. The second sensor 30 measures an electric current exiting the corresponding battery cell string 22. The trigger event occurs, when the measurement of the first sensor 28 and the measurement of the second sensor 30 deviate from each other by at least the predefined calibration threshold, e.g. 10%.

Further, in another example, the trigger event is determined using an artificial neural network.

In more detail, the artificial neural network learns, which deviations from normal measurements are significant or relevant. As a result, the artificial neural network can dynamically adjust the predefined calibration threshold to determine more precise trigger events.

Further, the artificial neural network can detect inconsistencies between the measurements of the first sensor 28 and the second sensor 30. Consequently, the artificial neural network allows a calibration as soon as the inconsistent measurements show a certain deviation pattern.

It is understood that the same method may be executed for each of the first sensors 28 and second sensors 30 of the battery cell strings 22 such that in the end, each of the first sensors 28 of the three sensor assemblies 26 is calibrated.

As used herein, the phrase "at least one" in reference to a list of one or more entities should be understood to mean at least one entity selected from any one or more of the entities in the list of entities, but not necessarily including at least one of each and every entity specifically listed within the list of entities and not excluding any combinations of entities in the list of entities. This definition also allows that entities may optionally be present other than the entities specifically identified within the list of entities to which the phrase "at least one" refers, whether related or unrelated to those entities specifically identified. Thus, as a non-limiting example, "at least one of A and B" (or, equivalently, "at least one of A or B," or, equivalently "at least one of A and/or B") may refer, in one example, to at least one, optionally including more than one, A, with no B present (and optionally including entities other than B); in another example, to at least one, optionally including more than one, B, with no A present (and optionally including entities other than A); in yet another example, to at least one, optionally including more than one, A, and at least one, optionally including more than one, B (and optionally including other entities). In other words, the phrases "at least one," "one or more," and "and/or" are open-ended expressions that are both conjunctive and disjunctive in operation. For example, each of the expressions "at least one of A, B, and C," "at least one of A, B, or C," "one or more of A, B, and C," "one or more of A, B, or C," and "A, B, and/or C" may mean A alone, B alone, C alone, A and B together, A and C together, B and C together, A, B, and C together, and optionally any of the above in combination with at least one other entity.

Other variations to the disclosed examples can be understood and effected by those skilled in the art in practicing the claimed disclosure, from the study of the drawings, the disclosure, and the appended claims. In the claims the word "comprising" does not exclude other elements or steps and the indefinite article "a" or "an" does not exclude a plurality. A single processor or other unit may fulfill the functions of several items or steps recited in the claims. The mere fact that certain measures are recited in mutually different dependent claims does not indicate that a combination of these measures cannot be used to advantage. A computer program may be stored/distributed on a suitable medium such as an optical storage medium or a solid-state medium supplied together with or as part of other hardware, but may also be distributed in other forms, such as via the Internet or other wired or wireless telecommunication systems. Any reference signs in the claims should not be construed as limiting the scope of the claims.

### LIST OF REFERENCE SIGNS

- 10: vehicle
- 12: drive unit
- 14: electric machine
- 16: drive shaft
- 18: battery assembly
- 20: battery cell
- 22: battery cell string
- 24: inverter unit
- 26: sensor assembly
- 28: first sensor
- 30: second sensor
- 32: master board

## Claims

1. A sensor assembly (26) for a battery cell string (22) of a battery assembly (18) for a vehicle (10), the sensor assembly (26) comprising
a plurality of first sensors (28) each configured to measure an electric current, wherein each first sensor (28) is associateable to a single battery cell (20) or a group of battery cells of the battery cell string (22), and
a second sensor (30) configured to measure an electric current, wherein the second sensor (30) is associateable to the battery cell string (22),
wherein the first sensors (28) and the second sensor (30) have different measurement accuracies, and wherein the first sensors (28) and the second sensor (30) are communicatively connected.

2. The sensor assembly (26) of claim 1, wherein the first sensors (28) use a first sensor technology and the second sensor (30) uses a second sensor technology which is different from the first sensor technology.

3. The sensor assembly (26) of claim 1 or 2, wherein the first sensors (28) and the second sensor (30) are wirelessly connected to each other.

4. A battery assembly (18) for a vehicle (10), the battery assembly (18) comprising:
- at least one sensor assembly (26) of any one of the preceding claims,
- a plurality of battery cells (20) arranged in at least one battery cell string (22), wherein each first sensor (28) of the sensor assembly (26) is associated to a single battery cell (20) or a group of battery cells of the battery cell string (22), and
wherein the second sensor (30) of the sensor assembly (26) is associated to the battery cell string (22).

5. The battery assembly (18) of claim 4, wherein each battery cell string (22) is equipped with a sensor assembly (26) of any one of claims 1 to 3.

6. A vehicle (10) comprising a battery assembly (18) of claim 4 or 5.

7. A method for controlling a sensor assembly (26) of claims 1 to 3, the method comprising calibrating at least one of the first sensors (28) based on a measurement by the second sensor (30).

8. The method of claim 7, wherein the calibration is time-triggered, event-triggered or regular.

9. The method of claim 8, wherein a trigger event relates to a measurement result of a first sensor (28) deviating from a measurement result of the second sensor (30) by more than a predefined calibration threshold.

10. The method of claim 8 or 9, wherein a trigger event is determined using an artificial neural network.
